# EUROPEAN PATENT APPLICATION

(11) **EP 4 811 540 A1**
(43) Date of publication of application: **23.09.2026**
(21) Application number: 25164959.6
(22) Date of filing: 20.03.2025
(51) Int. Cl.: H01P 1/32, H01P 1/37

(54) **BROADBAND NON-RECIPROCAL COUPLING BETWEEN ASYMMETRIC TRANSMISSION LINES**

(71) Applicant: Imec VZW, 3001 Leuven (BE); Katholieke Universiteit Leuven, 3000 Leuven (BE)
(72) Inventor: Demarets, Mael, 1170 Watermael-Boitsfrot (BE); Ananthapadmanabha Rao, Vadiraj Manjunath, 9051 Ghent (BE); De Greve, Kristiaan, 3001 Heverlee (BE); Caloz, Christophe, 3050 Oud-Heverlee (BE)
(74) Representative: Roth, Sebastian

(57) **Abstract**

The present disclosure relates to transmission lines, and is particularly concerned with coupling of electromagnetic waves between two transmission lines. A device and method are presented, which enable broadband non-reciprocal coupling of the electromagnetic waves between two asymmetric transmission lines. This is achieved by controlling individually a set of tunable impedance elements, which are distributed along at least one of the transmission lines, to generate a set of impedance modulations in the transmission line, and with each impedance modulation new tones in the electromagnetic waves propagating in the transmission line. Depending on the direction of propagation of the electromagnetic waves, the new tones may constructively or destructively interfere with modes of the other transmission line, leading to the non-reciprocal coupling.

## Description

### TECHNICAL FIELD

The present disclosure relates to transmission lines and communication via transmission lines. The disclosure relates both to optical transmission via waveguides as the transmission lines, and radio frequency (RF) transmission via RF transmission lines. The disclosure is particularly concerned with coupling of electromagnetic waves between two transmission lines. Thereby, the disclosure aims for broadband non-reciprocal coupling of the electromagnetic waves between two asymmetric transmission lines.

### BACKGROUND

Non-reciprocal devices are ubiquitous in many technical applications, for example, in microwave circuits used for antenna multiplexing, or reflection-based amplifiers, or shielding sources from backscattered signals. Conventionally, such non-reciprocal devices, for instance for microwave circuits, rely on a ferrite that is biased by a strong magnetic field to break reciprocity. Because of the ferrite and the magnet that generates the magnetic field, such non-reciprocal devices are bulky, i.e. they typically have a size in the range of tens of millimeters, and cannot be integrated on a chip. Moreover, the rather large magnetic fields can disturb superconductivity, and hence can deteriorate the performance of superconducting circuits, such as those used in quantum computers or other ultra-low noise applications.

For this reason, alternatives to the ferrite-based solution have been proposed, and can be distinguished into the following three classes. The first class relies on transistors, which when biased appropriately are intrinsically non-reciprocal due to their unilateral gain. However, the bias current results in resistive dissipation, Joule heating, and increased thermal noise. The second class relies on non-linear media and asymmetric field distribution. However, this approach is only effective for non-simultaneous electromagnetic signals above a certain amplitude, such that they can trigger the non-linear response of the medium. The third class relies on parametric modulation to split electromagnetic signals into multiple modes and engineer a direction-dependent interference between these modes. Yet, this interference-based approach to non-reciprocity has only been shown to work on a rather limited range of frequencies.

### SUMMARY

In view of the above, an objective of this disclosure is to provide an improved solution for non-reciprocal devices, which allow avoiding the above-mentioned drawbacks. For instance, an objective is to avoid strong magnetic fields. Another objective is to avoid dissipation, heating and noise, which is inherent to the transistor-based approaches. Another objective is to avoid the dependence on the amplitude of electromagnetic waves, which is inherent to the approaches using non-linear media. Another objective is to avoid the reciprocal behavior of non-linear media for simultaneous inputs on opposite ports. Another objective is to avoid the limited operational bandwidth of the approaches that are based on modulations and interfering modes.

In sum, a compact device for efficient broadband non-reciprocal electromagnetic signal transmission is desired.

The above and other objectives are achieved by the solutions presented in this disclosure, as described in the independent claims. Advantageous implementations are described in the dependent claims.

A first aspect of this disclosure provides a device for non-reciprocal signal transmission, the device comprising a first transmission line having a first set of electromagnetic modes supporting the propagation of electromagnetic waves at a first phase velocity; a second transmission line having a second set of electromagnetic modes supporting the propagation of electromagnetic waves at a second phase velocity distinct from the first phase velocity; and a set of first tunable impedance elements distributed along the first transmission line; a controller configured to control the set of first tunable impedance elements to generate a set of impedance modulations in the first transmission line, each impedance modulation of the set producing new tones in the electromagnetic waves propagating in the first transmission line; wherein the controller is configured to individually control each first tunable impedance element to generate the set of impedance modulations with a particular set of associated phases, such that for a first direction of propagation of the electromagnetic waves in the first transmission line, the new tones in the electromagnetic waves in the first transmission line constructively interfere and couple to modes of the second transmission line, and for an opposite second direction of propagation of the electromagnetic waves in the first transmission line, the new tones in the electromagnetic waves in the first transmission line destructively interfere and do not couple to the modes of the second transmission line.

The device of the first aspect can be built in a compact way, without the bulkiness of the ferrite-based approaches. Further, it enables broadband non-reciprocal electromagnetic signal transmission. Magnetic fields are not required, and also no biased transistors, of which the bias currents would result in resistive dissipation, Joule heating, and thermal noise.

The unequal phase velocities of the two transmission lines prevent coupling of the electromagnetic waves between the two transmission lines, when the controller applies no interference modulations via the impedance modulation elements. The unequal phase velocities in this case result in destructive interference between electromagnetic waves propagating in the two transmission lines, hence preventing coupling despite the presence of passive electromagnetic coupling.

Each impedance modulation distorts the electromagnetic field in the first transmission line, and thus produces the new tones. Notably, electromagnetic fields can be decomposed as a series of electromagnetic waves, where each electromagnetic wave can be seen as an excitation of a mode. Whether the electromagnetic field carries information or not is not relevant, so the electromagnetic waves may be a signal and/or noise

In an implementation of the device, the set of first tunable impedance elements comprises one of superconducting quantum interference devices configured to be modulated by an external flux, voltage-controlled capacitors configured to be controlled by an external voltage, Josephson junctions, kinetic inductances, a material with second or third order nonlinearity, or any other nonlinear elements configured to be impedance modulated by a pump signal.

The external flux or external voltage may be considered the pump signal for the first two alternatives. Generally, a pump signal may carry information, for instance, the specific frequency and phases.

In an implementation of the device, the controller is configured to control the set of first tunable impedance elements to generate the set of impedance modulations at a first frequency and with an associated set of phases, to realize nonreciprocal coupling between electromagnetic waves supported by an electromagnetic mode of the first transmission line and propagating in the first direction of propagation and electromagnetic waves supported by an electromagnetic mode of the second transmission line and propagating in the same first direction of propagation.

Thus, in the device of the first aspect, non-reciprocal coupling can be achieved between electromagnetic waves that are propagating in the same direction. It is also possible to realize non-reciprocal coupling between co-propagating electromagnetic waves supported by modes of the same transmission line.

In an implementation of the device, the controller is configured to control the set of first tunable impedance elements to generate the set of impedance modulations at a first frequency with an associated set of phases, to realize nonreciprocal coupling between electromagnetic waves supported by an electromagnetic mode of the first transmission line and propagating in the first direction of propagation and electromagnetic waves supported by an electromagnetic mode of the second transmission line and propagating in the second direction of propagation

Thus, in the device of the first aspect, non-reciprocal coupling can be achieved between electromagnetic waves that are propagating in the opposite directions. It is also possible to realize non-reciprocal coupling between counter-propagating electromagnetic waves supported by modes of the same transmission line.

In an implementation of the device, the controller is configured to control the set of first tunable impedance elements to generate the set of impedance modulations at a plurality of frequencies with associated sets of phases, to realize a set of nonreciprocal couplings between electromagnetic waves supported by electromagnetic modes of one of the two transmission lines and electromagnetic waves supported by electromagnetic modes of the other transmission line.

Thus, in the device of the first aspect, a multi-tone modulation can produce multiple non-reciprocal couplings.

In an implementation of the device, one modulation frequency and the associated set of phases are configured to realize non-reciprocal coupling and directional exchange of energy between electromagnetic waves supported by an electromagnetic mode of the first transmission line and electromagnetic waves supported by an electromagnetic mode of the second transmission line.

Thus, non-reciprocal coupling between electromagnetic waves supported by two modes can lead to energy exchange between the modes. Notably, there can be other modulation frequencies resulting in other simultaneous non-reciprocal coupling between a different set of modes. The term "directional exchange" indicates that energy typically flows back-and forth between the two coupled modes in the direction where they are coupled. In the reverse direction, the two modes are uncoupled, so no exchange of energy occurs.

In an implementation of the device, one modulation frequency and the associated set of phases are configured to realize non-reciprocal coupling and directional amplification of an electromagnetic wave propagating in the first transmission line and an electromagnetic wave propagating in the second transmission line.

Thus, the non-reciprocal coupling can also be used to achieve "parametric" amplification and/or parametric "conversion". The only difference is in the frequency and phase of the impedance modulations, which is used to get this type of non-reciprocal coupling scheme.

In an implementation of the device, non-reciprocal coupling between electromagnetic waves supported by an electromagnetic mode of one of the two transmission lines designed with lower losses and electromagnetic waves supported by an electromagnetic mode of the other transmission line designed with higher losses is configured to produce nonreciprocal electromagnetic field attenuation.

In an implementation of the device, the device further comprises a set of second tunable impedance elements distributed along the second transmission line; wherein the controller is configured to control the set of second tunable impedance elements to generate a second set of impedance modulations in the second transmission line, each impedance modulation of the second set producing new tones in the electromagnetic waves propagating in the second transmission line; wherein the controller is configured to individually control each second tunable impedance element to generate the second set of impedance modulations with a particular set of associated phases, such that for the first direction of propagation of the electromagnetic waves in the second transmission line, the new tones in the electromagnetic waves in the second transmission line constructively interfere and couple to modes of the first transmission line, and for the opposite second direction of propagation of the electromagnetic waves in the second transmission line, the new tones in the electromagnetic waves in the second transmission line destructively interfere and do not couple to the modes of the first transmission line.

Accordingly, in the device of the first aspect, impedance modulations may be generated in one of the two transmission lines, or in both of the two transmission lines. As already described above for the first transmission line, the impedance modulations in the second transmission line distort the electromagnetic field of electromagnetic waves propagating on the transmission lines and produces the new tones.

In an implementation of the device, the first transmission line and the second transmission line are configured to have respective electromagnetic modes with dispersion curves that are parallel to each other over a predetermined range of frequencies.

In other words, the dispersion of the first and second transmission lines are engineered such that, over a predetermined range of frequencies, any two electromagnetic modes that are separated by a given frequency shift will show the same phase-shift/difference in phase velocity.

While non-reciprocal coupling between the transmission lines can be obtained without the dispersion curve engineering, the engineering of the dispersion curves offers the possibility to obtain non-reciprocal coupling over the predetermined range of frequencies with a single modulation frequency and the associated set of phases.

In an implementation of the device, the electromagnetic waves are RF waves or RF noise, or the electromagnetic waves are optical waves or optical noise and the transmission lines are waveguides.

The device of the first aspect can thus be realized and used for RF and optical communication applications.

A second aspect of this disclosure provides a method of operating a device for non-reciprocal signal transmission, the method comprising propagating electromagnetic waves supported by a first set of electromagnetic modes of a first transmission line at a first phase velocity in a first direction or in an opposite second direction; propagating electromagnetic waves supported by a second set of electromagnetic modes of a second transmission line at a second phase velocity in the first direction or in the second direction; and controlling a set of first tunable impedance elements, which are distributed along the first transmission line, to generate a set of impedance modulations in the first transmission line, each impedance modulation of the set producing new tones in the electromagnetic waves propagating in the first transmission line; wherein each first tunable impedance element is individually controlled to generate the set of impedance modulations with a particular set of associated phases, such that for a first direction of propagation of the electromagnetic waves in the first transmission line, the new tones in the electromagnetic waves in the first transmission line constructively interfere and couple to modes of the second transmission line, and for an opposite second direction of propagation of the electromagnetic waves in the first transmission line, the new tones of the electromagnetic waves in the first transmission line destructively interfere and do not couple to the modes of the second transmission line.

The method of the second aspect may have implementations that correspond to the implementations of the device of the first aspect. The method of the second aspect and its implementations achieve the effects and advantages described above for the device of the first aspect and its implementations.

The device and method of this disclosure solve all the issues of the different approaches mentioned above. In particular, the solutions of this disclosure enable non-reciprocal transmission while avoiding all of the following: (i) bulky magnets and strong magnetic fields, which prevent conventional non-reciprocal devices from being integrated on-chip and/or with superconducting circuits; (ii) dissipation, heating and noise, inherent to the transistor-based solutions; (iii) the dependence on the amplitude inherent to devices using non-linear media; (iv) the reciprocal behavior of non-linear media for simultaneous inputs on opposite ports; (v) the limited operational bandwidth of the devices based on modulations and interfering modes.

### BRIEF DESCRIPTION OF THE DRAWINGS

The above described aspects and implementations are explained in the following description of embodiments with respect to the enclosed drawings:
- FIG. 1: shows a device for non-reciprocal transmission according to an exemplary embodiment of this disclosure.
- FIG. 2: shows a device for non-reciprocal transmission according to an exemplary embodiment of this disclosure.
- FIG. 3: shows an example of asymmetric coupled transmission lines in a device according to an exemplary embodiment of this disclosure.
- FIG. 4: shows modulated asymmetric coupled transmission lines in a device according to an exemplary embodiment of this disclosure.
- FIG. 5: illustrates non-reciprocal parametric coupling in a device according to an exemplary embodiment of this disclosure.
- FIG. 6: illustrates directional energy exchange and amplification with non-reciprocal parametric coupling in a device according to an exemplary embodiment of this disclosure.
- FIG. 7: illustrates non-reciprocal parametric coupling between arbitrary propagating electromagnetic waves in a device according to an exemplary embodiment of this disclosure.
- FIG. 8: illustrates multi-tone parametric modulation with multiple non-reciprocal couplings in a device according to an exemplary embodiment of this disclosure.
- FIG. 9: illustrates dispersion engineering of the transmission lines for a device according to an exemplary embodiment of this disclosure.
- FIG. 10: illustrates exemplary implementations of the impedance modulation elements of a device according to an exemplary embodiment of this disclosure.
- FIG. 11: illustrates an implementation of the impedance modulation elements as varactors, in a device according to an exemplary embodiment of this disclosure.
- FIG. 12: illustrates an implementation of the impedance modulation elements as SQUIDs, in a device according to an exemplary embodiment of this disclosure.
- FIG. 13: shows a flow-diagram of a method of operating a device according to an exemplary embodiment of this disclosure.

### DETAILED DESCRIPTION OF EMBODIMENTS

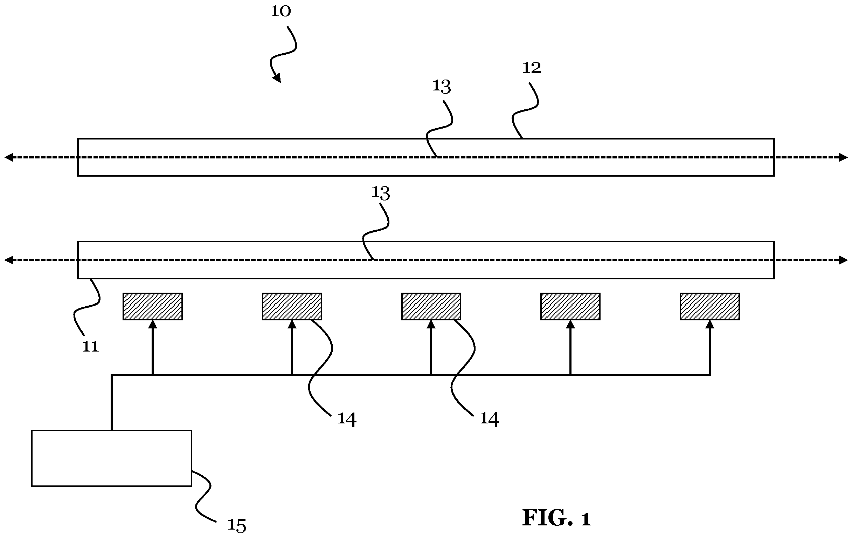

FIG. 1 shows schematically a device 10 according to this disclosure. The device 10 is configured for implementing non-reciprocal signal transmission, wherein the signal is provided by electromagnetic waves. Non-reciprocal transmission may mean that signal transmission between any two ports of the device 10 depends on the direction of propagation of the signal..

Non-reciprocal transmission may mean that the electromagnetic waves propagating on any of the two lines in the device 10 can couple to the other line when propagating in one direction, but are decoupled from the other line when propagating in the opposite direction.

The device 10 comprises a first transmission line 11, which has a first set of electromagnetic modes that support the propagation of the electromagnetic waves 13 at a first phase velocity. The device 10 further comprises a second transmission line 12, which has a second set of electromagnetic modes that support the propagation of the electromagnetic waves 13 at a second phase velocity distinct from the first phase velocity. The two transmission lines 11, 12 may in principle be arranged to electromagnetically couple, e.g., they are close enough together and are not shielded from each other, to allow passive electromagnetic coupling.

However, the electromagnetic coupling of the electromagnetic waves 13 between the transmission lines is tunable, as will become evident in the further description.

The device 10 further comprises a set of first tunable impedance elements 14, which are arranged or distributed along the first transmission line 11. For instance, the first tunable impedance elements 14 may be arranged one after the other and/or at regular intervals along the extension direction of the first transmission line 11. The tunable impedance elements 14 may all be of the same type.

Further, the device 10 comprises a controller 15, which is configured to control the set of first tunable impedance elements 14. The controller 15 is configured to control each tunable impedance element individually. For instance, the controller 15 may be any unit capable of providing a control signal or pump signal to each of the first impedance elements 14. The controller may be a processor, but may also be a voltage or current source. The controller 15 is specifically configured to control the tunable impedance elements 14 such that they generate a set of impedance modulations in the first transmission line 11. Each impedance modulation of the set of impedance modulations produces new tones in the electromagnetic waves 13 that propagate in the first transmission line 11, i.e., new frequencies. Electromagnetic waves 13 in the transmission lines may be signals and/or noise.

The controller 15 is configured to control each first tunable impedance element 14 to generate the set of impedance modulations with a particular set of associated phases. Thereby, these associated phases are selected such (e.g., by the controller 15) that the coupling between the two transmission lines becomes different for different propagation directions of the electromagnetic waves 13. In particular, for a first direction of propagation of the electromagnetic waves 13 in the first transmission line 11, the new tones in the electromagnetic waves 13 in the first transmission line 11 constructively interfere with and couple to modes of the second transmission line 12. For an opposite second direction of propagation of the electromagnetic waves 13 in the first transmission line 11, the new tones in the electromagnetic waves 13 in the first transmission line 11 destructively interfere with and do not couple to the modes of the second transmission line 12. In this way, non-reciprocal transmission of the electromagnetic waves 13 (e.g. of a signal) through the transmission lines 11, 12 of the device can be achieved, as the coupling depends on the propagation direction.

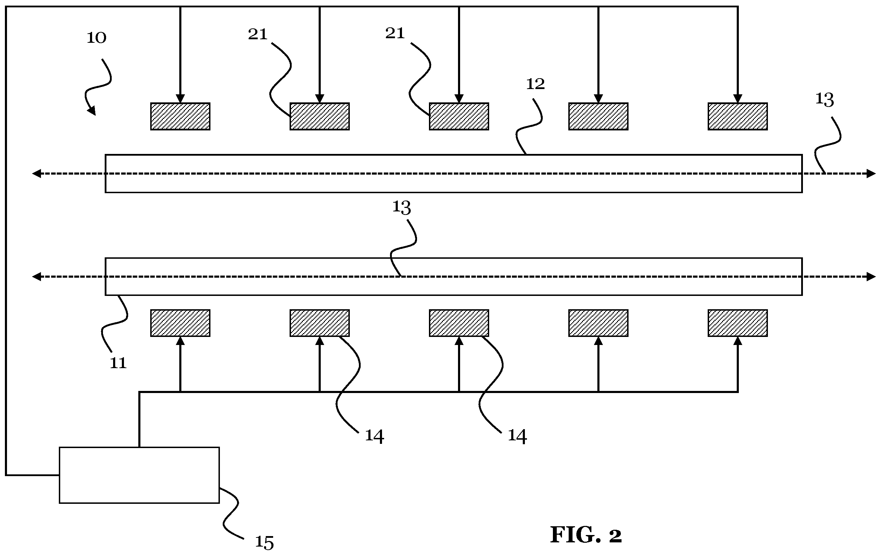

FIG. 2 shows a device 10 according to an exemplary embodiment of this disclosure, which builds on the device 10 shown in FIG. 1. Same elements in FIG. 1 and FIG. 2 are labelled with the same reference sign, may be implemented likewise, and are not described redundantly.

The device 10 of FIG. 2 comprises, in addition to the set of tunable impedance elements 14, a set of second tunable impedance elements 21, which are arranged or distributed along the second transmission line 12. In an exemplary configuration, no tunable impedance elements are arranged between the two transmission lines 11, 12, however, this is also possible. For instance, the second tunable impedance elements 21 may be arranged one after the other and/or at regular intervals along the extension direction of the second transmission line 12. The tunable impedance elements 21 may all be of the same type.

The first tunable impedance elements 14 and/or the second impedance elements 21 shown in FIG. 1 or FIG. 2, may respectively be superconducting quantum interference devices configured to be modulated by an external flux, or voltage-controlled capacitors configured to be controlled by an external voltage, or Josephson junctions, or kinetic inductances, or materials with second or third order nonlinearity, or any other nonlinear elements configured to be impedance modulated by a pump signal (e.g. provided by the controller 15). This will be explained in more detail later.

The controller 15 of the device 10 shown in FIG. 2 is further configured to also control the set of second tunable impedance elements 21. The controller 15 is configured to control each tunable impedance element individually. The controller 15 is specifically configured to control the second tunable impedance elements 21 such that they generate a second set of impedance modulations in the second transmission line 12. Each impedance modulation of the second set of impedance modulations produces new tones in the electromagnetic waves 13 that propagate in the second transmission line 12.

The controller 15 is configured to control each second tunable impedance element 21 to generate the set of impedance modulations with a particular set of associated phases. Thereby, these associated phases are selected such (e.g., by the controller 15) that coupling between the two transmission lines is different for different propagation directions of electromagnetic waves 13. In particular, for a first direction of propagation of the electromagnetic waves 13 in the second transmission line 12, the new tones in the electromagnetic waves 13 in the second transmission line 12 constructively interfere with and couple to modes of the first transmission line 11. For the opposite second direction of propagation of the electromagnetic waves 13 in the second transmission line 12, the new tones in the electromagnetic waves 13 in the second transmission line 12 destructively interfere with and do not couple to the modes of the first transmission line 11. In this way, non-reciprocal transmission of the electromagnetic waves 13, e.g. of a signal, can be achieved.

The solutions of this disclosure, as for instance realized in the above-described device 10 of FIG. 1 and FIG. 2, are based on integrated asymmetric coupled transmission lines 11, 12, and a set of impedance modulations generated in at least one of the transmission lines 11, 12, in order to introduce the non-reciprocal coupling between the transmission lines 11, 12. The set of impedance modulations may be equivalent to a propagating impedance modulation generated in at least one of the transmission lines 11, 12. More detailed explanations are provided in the following description of examples and exemplary embodiments.

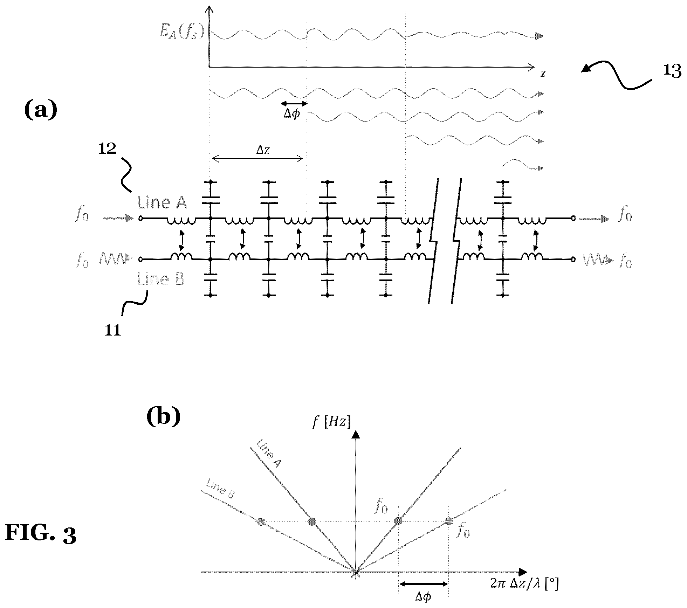

As shown in FIG. 3(a), two transmission lines 11, 12 can be designed asymmetrically, i.e., they propagate electromagnetic waves 13 with different phase velocities. In the absence of impedance modulations, such transmission lines 11, 12 prevent that electromagnetic waves couple efficiently from one transmission line to the other. In particular, a fraction of the electromagnetic waves 13 propagating in the first transmission line 11 and coupling to the second transmission line 12 (or vice versa), will acquire a certain phase shift Δ*ϕ* compared to the electromagnetic waves 13 remaining in the first transmission line 11. As the electromagnetic waves 13 propagate and couple to the second transmission line 12 at different points in space, the interference in the second transmission line 12 at each point will in general be destructive, because of the phase mismatch. That is, the unequal phase velocities of the transmission lines 11, 12 result in destructive interference, which prevents propagating electromagnetic waves 13 from coupling efficiently between the two transmission lines 11, 12, despite the presence of passive electromagnetic coupling. This can be seen in the dispersion diagram shown in FIG. 3(b), in which, for a propagation length Δ*z*, the unequal phase velocities *v*_{*A*/*B*} = *f₀*/*λ*_{*0,A*/*B*} translate into the phase difference Δ*ϕ*.

However, this phase mismatch can be compensated for by generating the set of impedance modulations in at least one of the two transmission lines 11, 12 with the impedance modulation elements 14 and/or 21 (e.g., flux-modulated SQUIDs, Josephson junctions, varactors, etc.).

In a linear time-invariant system, i.e., where parameters are constant over time (unmodulated case), the electromagnetic waves 13 propagate and accumulate a certain delay and phase different, but the spectrum of the electromagnetic waves 13 stays unchanged. On the contrary, in a linear time-variant system, i.e. where parameters vary over time - in this case the impedance due to the set(s) of impedance modulations - the electromagnetic field is distorted, and new tones appear in the spectrum of the electromagnetic waves 13. These new tones are intermodulation products. For instance, by modulating the impedance of one of the transmission lines at a certain frequency, a three-wave mixing processes can produce a frequency up/down-conversion accompanied by a phase shift that depends on the phase of the impedance modulation. Based on the appearance of these intermodulation products, the set of impedance modulations (or other wave-mixing process) produces the new tones, which involves coupling the input power from electromagnetic waves 13 propagating supported by one mode to another. This is called parametric coupling. Notably, these parametric conversions do not dissipate any power on-chip and are noise-less processes.

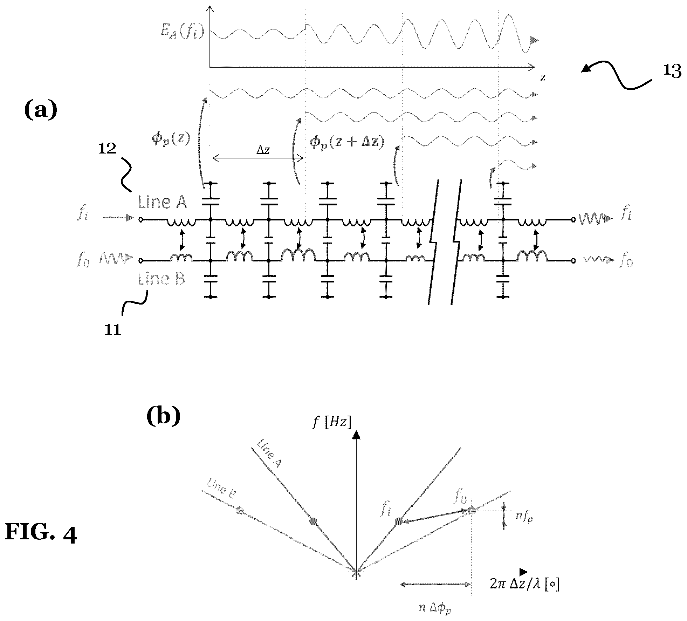

FIG. 4 explains how this can be used for non-reciprocal transmission in the device 10. For example, multiple impedance modulations can be generated by the impedance modulations elements 14, which distort the electromagnetic field in the first transmission line 11 and produce a series of new tones in the electromagnetic waves 13 propagating in the first transmission line 11, shown in FIG. 4(a). By controlling the phases of these impedance modulations of the individually controlled impedance modulation elements 14, it is possible to control the phases of the new tones, and to make the new tones couple and interfere constructively on the second transmission line 12. In the dispersion diagram in FIG. 4(b), the impedance modulations are represented by arrow(s). If the impedance modulations have a proper frequency *fₚ* and associated phases {*ϕₚ*(*z*)}, they can couple two electromagnetic waves 13 propagating supported by modes of the other transmission line at *f*₀ and *fᵢ = f*₀ ± *nfₚ.*

In other words, it is possible with the controller 15 controlling the impedance modulation elements 14, to engineer the impedance modulations such that they cancel out the phase shift Δ*ϕ* that the electromagnetic waves 13 would acquire when propagating on different transmission lines 11, 12 without modulations. Notably, for an impedance modulation with a fixed set of phases, this phase-matching condition may not simultaneously be met in both directions of propagation. Hence, non-reciprocal coupling between the two transmission lines 11, 12 is achieved, that is, coupling which depends on the electromagnetic wave's 13 direction of propagation. Note that this non-reciprocal behavior holds regardless of the signal amplitude and for simultaneous excitations at opposite ports as well.

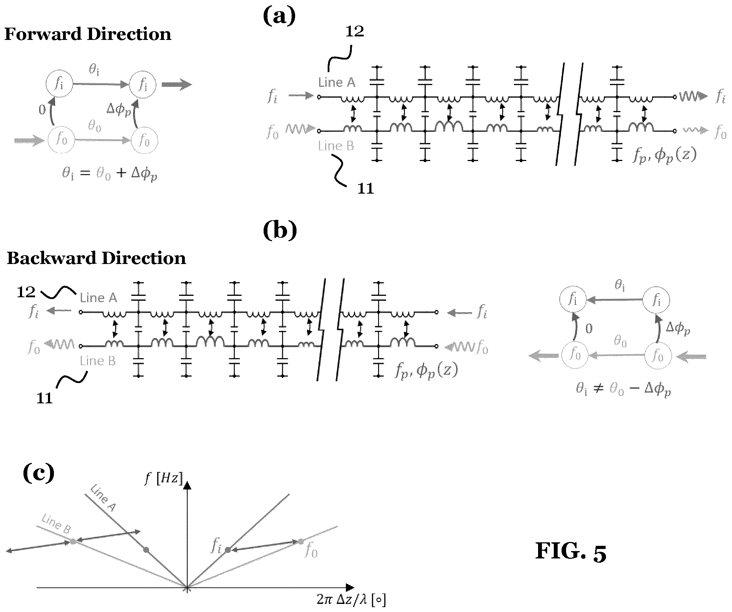

FIG. 5(a) and (b) illustrate non-reciprocal parametric coupling in modulated asymmetric coupled transmission lines. The phases of the impedance modulations produce the new tones in the first transmission line 11, wherein the new tones interfere constructively on the second transmission line 12 in one direction of propagation (forward direction), and destructively in the reverse direction (backward direction), hence, realizing the non-reciprocal coupling between the two transmission lines 11, 12. In the dispersion diagram shown in FIG. 5(c), a same modulation, i.e. arrow, cannot couple two modes *f*₀ and *fᵢ* in both forward and backward directions.

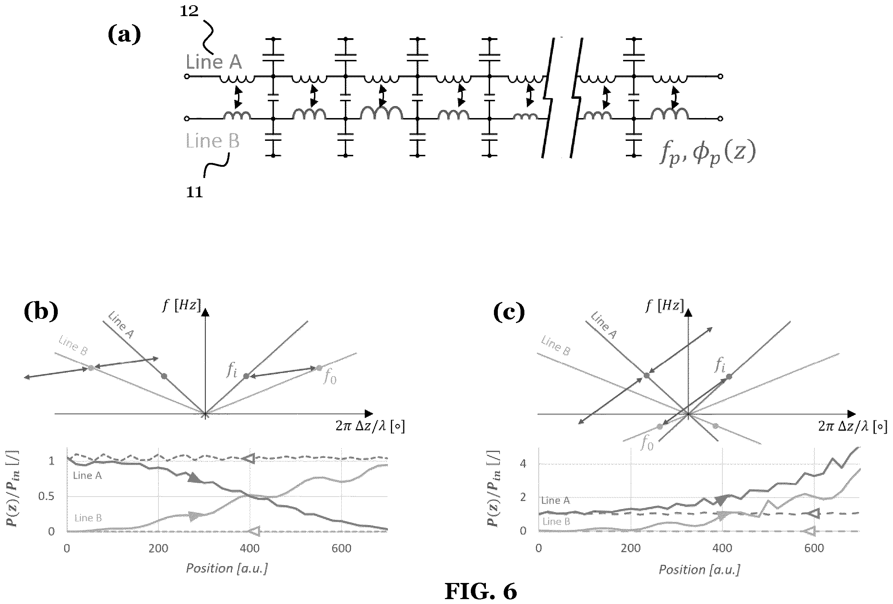

FIG. 6 illustrates an energy exchange and amplification enabled by the non-reciprocal parametric coupling in a device 10 according to an exemplary embodiment. The modulated asymmetric coupled transmission lines 11, 12 with the non-reciprocal coupling are shown in FIG. 6(a), and can display two different phenomena. With the appropriate modulation frequency and associated phases, the non-reciprocal coupling can firstly be used to realize a directional exchange of energy between two modes *f*₀ and *fᵢ* supporting electromagnetic waves 13 propagating on separate transmission lines 11, 12, as shown in FIG. 6(b). Secondly, by choosing the appropriate frequency and associated phases of the impedance modulations, directional amplification of the two modes *f*₀ and *fᵢ* supporting electromagnetic waves 13 propagating on separate transmission lines 11, 12 can be realized, as shown in FIG. 6(c).

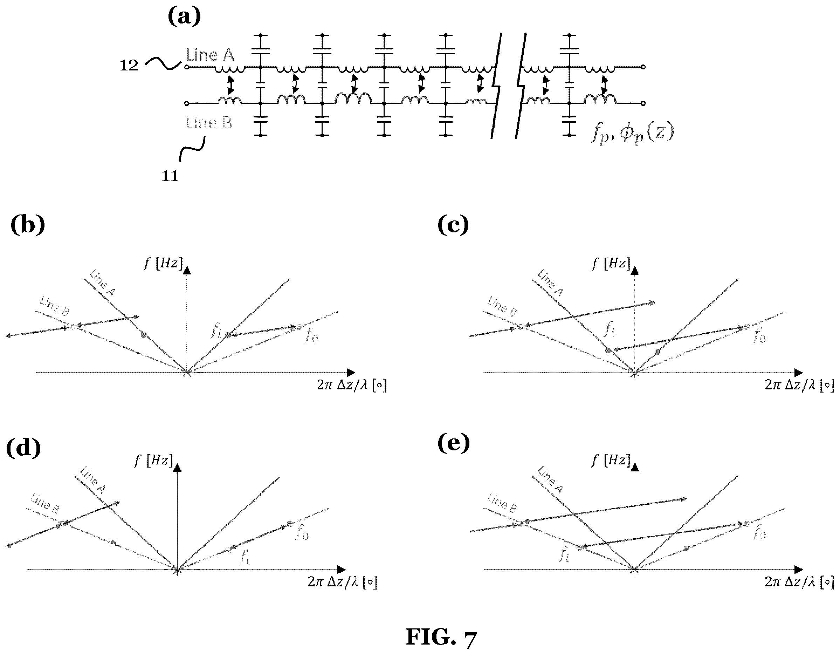

FIG. 7 illustrates non-reciprocal parametric coupling between arbitrary propagating electromagnetic waves 13 in a device 10 according to an exemplary embodiment. As described above, the modulated asymmetric coupled transmission lines 11, 12, which are shown in FIG. 7(a), with the appropriate modulation frequency and associated phases, can produce the non-reciprocal coupling between two modes *f*₀ and *fᵢ* supporting electromagnetic waves 13 propagating on separate transmission lines 11, 12, but in the same direction, as shown in FIG. 7(b). Alternatively, by choosing the appropriate frequency and associated phases, the same device 10 can couple electromagnetic waves 13 supported by modes on separate transmission lines 11, 12 and propagating in opposite directions, as shown in FIG. 7(c). Similarly, with the right modulation frequency and phases, electromagnetic waves 13 supported by modes inside the modulated transmission line 11 and/or 12 can also be non-reciprocally coupled, whether they are propagating in the same direction shown in FIG. 7(d) or in opposite direction shown in FIG. 7(e)

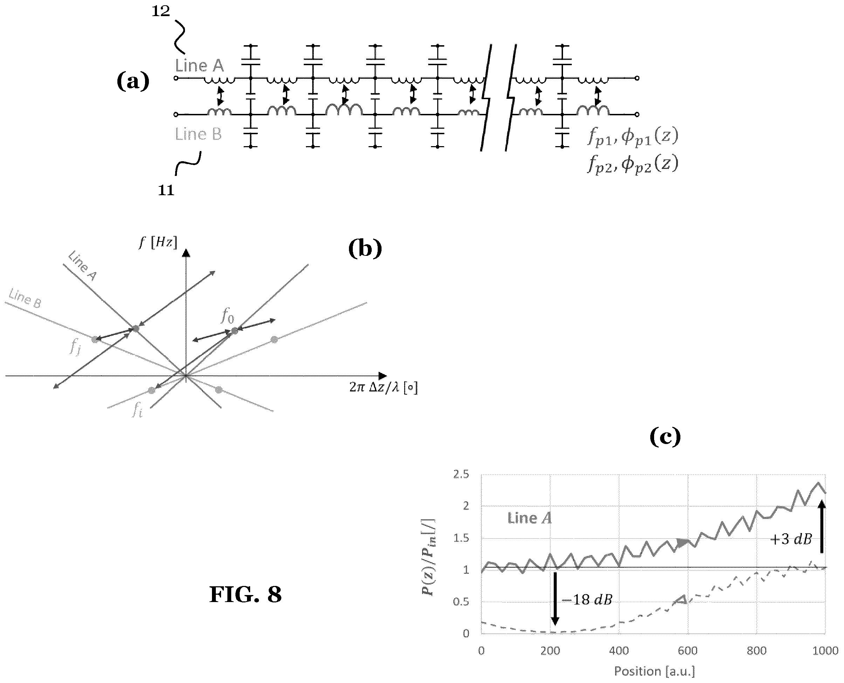

FIG. 8 illustrates multi-tone parametric modulation with multiple non-reciprocal couplings in a device 10 according to an exemplary embodiment. Considering modulated asymmetric coupled transmission lines 11, 12, which are shown in FIG. 8(a), wherein the modulation comprises a plurality of frequencies {*fₚ*} with their associated phases {*ϕₚ*(*z*)}, each frequency component *fₚ* with the appropriate phases *ϕₚ* results in non-reciprocal coupling between electromagnetic waves 13 propagating on the transmission lines 11, 12. For example, considering a two-tone modulation, i.e. two arrows in FIG. 8(b), one tone provides amplification in the forward direction, and the second tone converts the electromagnetic waves 13 to the second transmission line 12 in the reverse direction as shown in FIG. 8(c).

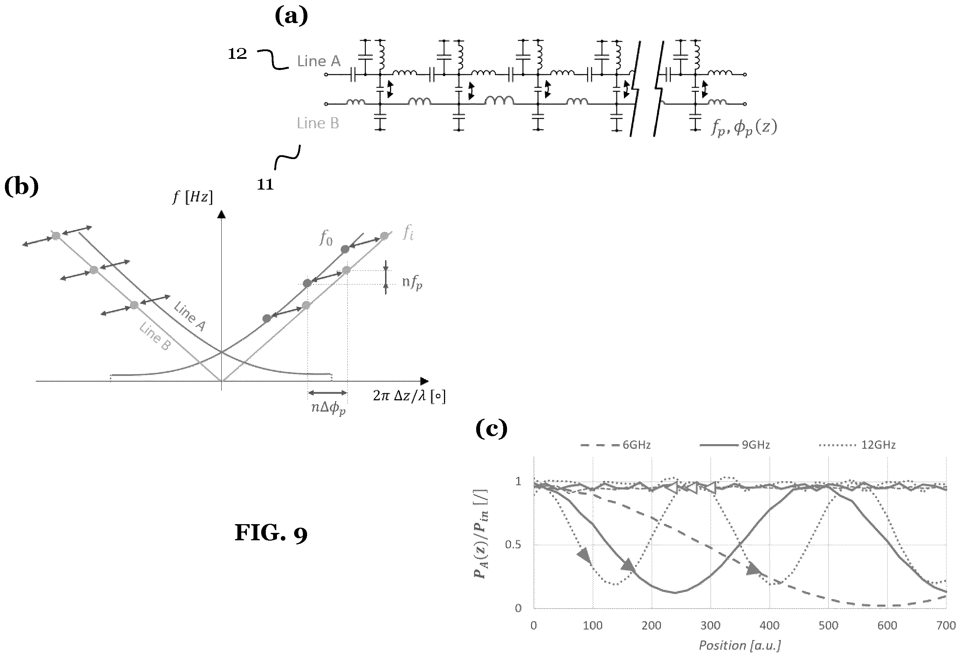

FIG. 9 illustrates dispersion engineering of the transmission lines 11, 12 for a broadband device 10 according to an exemplary embodiment. The two asymmetric coupled transmission lines 11, 12 can be engineered to have dispersion curves such that, over a predetermined range of frequencies, any two electromagnetic modes belonging to separate curves and separated by a given frequency shift *nfₚ* show the same phase-shift *nϕₚ.* In this way, non-reciprocal coupling between the two transmission lines 11, 12 can be obtained over the whole desired range of frequencies for a single impedance modulation frequency and associated set of phases. One possible embodiment is the device 10 shown in FIG. 9(a), which results in the dispersion curves shown in FIG. 9(b). As a result, directional exchange of energy between the two lines can be realized for any signal in the 6-12 GHz range with a single modulation frequency *fₚ* and associated set of phases {*ϕₚ*}, as shown in FIG. 9(c).

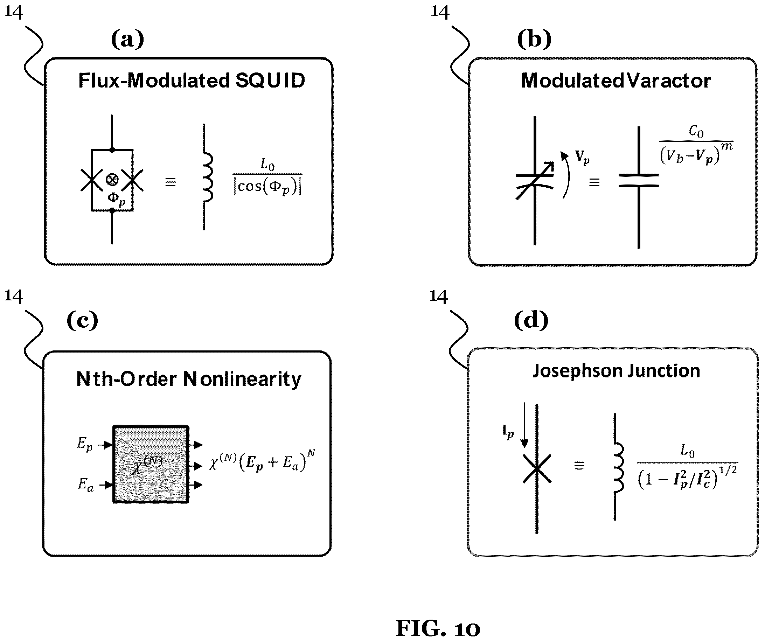

FIG. 10 illustrates exemplary implementations of the impedance modulation elements 14 and/or 21, and may be used for any device 10 described in this disclosure. To realize the impedance modulations with the controller 15, multiple impedance modulation elements 14 can be used. For example, superconducting quantum interference devices (SQUIDs) configured to be modulated by an external flux can be used, as shown in FIG. 10(a). Alternatively, varactors can be used as shown in FIG. 10(b), wherein a capacitance of the varactors is controlled by an external voltage. It is also possible to use Josephson junctions shown in FIG. 10(d), or an inductance of which is modulated by a pump current (provided by the controller 15). Similarly, one could use kinetic inductance, or materials with second, third order nonlinearity, or any other nonlinear element with an impedance that can be modulated by a pump signal, as shown in FIG. 10(c), or any other process that can realize a phase-preserving wave mixing process producing the new tones.

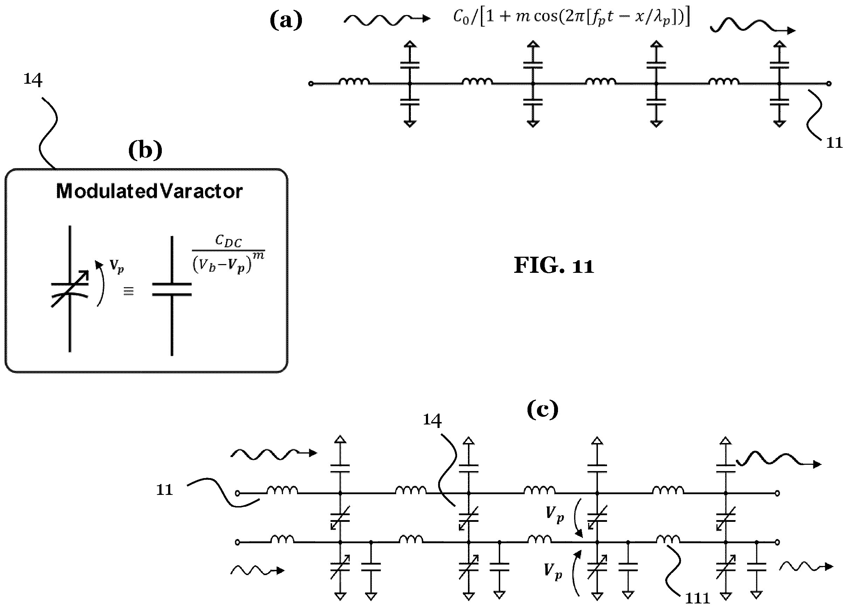

FIG. 11 illustrates a specific implementation of the impedance modulation elements as varactors as in FIG. 11(b). A pump signal propagating on an additional line 111, shown in FIG. 11(c), adjacent to the transmission line 11 of FIG. 11(a) may modulate the voltage seen by the varactor (across the varactor), changing its capacitance. If the adjacent pump line 111 has the right phase velocity, the pump will generate impedance modulation in the transmission line 11, with the adequate set of phases.

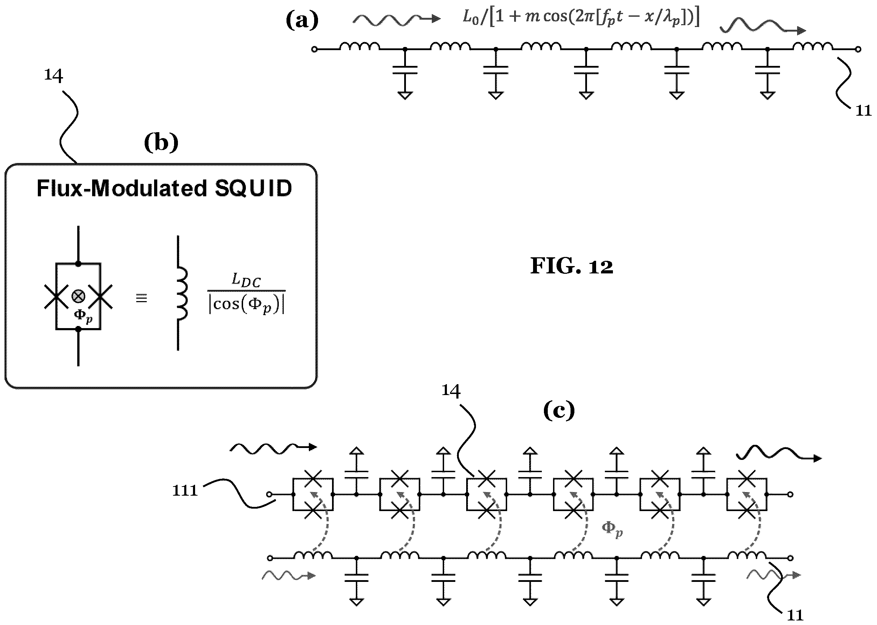

FIG. 12 illustrates a specific implementation of the impedance modulation elements 14 as SQUIDs as in FIG. 12(b). The SQUIDs' enclosed magnetic flux may again be modulated by a pump signal propagating on an adjacent line 111, as shown in FIG. 12(c). If the adjacent line 111 has the right phase velocity, the pump will generate impedance modulation in the transmission line 11 of FIG. 12(a), with the adequate set of phases.

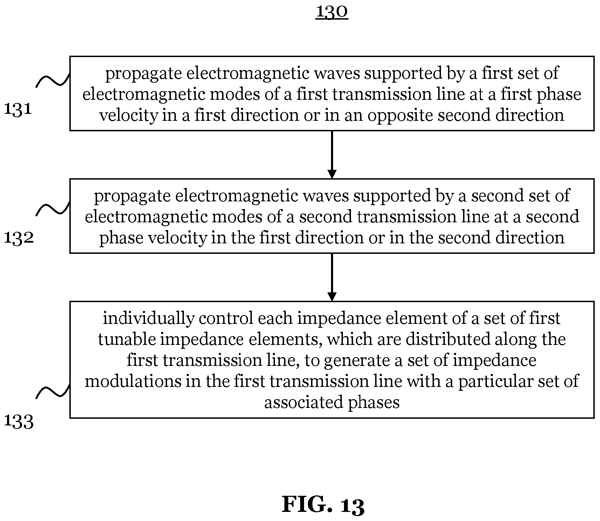

FIG. 13 shows a method 130 according to this disclosure, in particular, a flow diagram of method steps 131, 132, 133. The method 130 can be carried out to operate a device 10 for non-reciprocal signal transmission, for instance, as illustrated in the previous figures

Step 131 comprises propagating electromagnetic waves 13, which are supported by a first set of electromagnetic modes of a first transmission line 11 at a first phase velocity in a first direction or in an opposite second direction. Step 132 comprises propagating 132 electromagnetic waves 13, which are supported by a second set of electromagnetic modes of a second transmission line 12 at a second phase velocity in the first direction or in the second direction.

Step 133 comprises controlling a set of first tunable impedance elements 14, which are distributed along the first transmission line 11, to generate a set of impedance modulations in the first transmission line 11, Each impedance modulation of the set produces new tones in the electromagnetic waves 13 propagating in the first transmission line. The step 133 can individually control each first tunable impedance element 14 to generate the set of impedance modulations with a particular set of associated phases. The step 133 is thereby carried out such that for a first direction of propagation of the electromagnetic waves 13 in the first transmission line 11, the new tones in the electromagnetic waves 13 in the first transmission line 11 constructively interfere and couple to modes of the second transmission line 12, and such that for an opposite second direction of propagation of the electromagnetic waves 13 in the first transmission line 11, the new tones of the electromagnetic waves 13 in the first transmission line 11 destructively interfere and do not couple to the modes of the second transmission line 12.

In summary, this disclosure presents a device 10 and method 130 relying on asymmetric coupled transmission lines 11, 12 with an impedance-modulation-induced non-reciprocal coupling of electromagnetic waves 13 propagating in these transmission lines 11, 12. The unequal phase velocities of the transmission lines 11, 12 prevents strong coupling in the unmodulated case. However, by controlling at least one set of impedance modulation elements 14, 21 arranged along one or both of the transmission lines 11, 12, this phase mismatch can be compensated for, and stronger coupling can be obtained between the two transmission lines 11, 12. Moreover, the set of impedance modulations can be controller with respectively associated phases, such that the phase matching of propagating electromagnetic waves 13 only occurs in one direction of propagation and not the reverse, hence making the coupling between the two transmission lines 11, 12 non-reciprocal. Additionally, dispersion engineering may be used to ensure that the phase matching occurs over a wide range of frequencies, resulting in broadband non-reciprocity. The device 10 of this disclosure, with minor relative adjustments, could be used as a gyrator, circulator, isolator, directional amplifier, or even a combination of these effects in a same device 10.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A device (10) for non-reciprocal signal transmission, the device (10) comprising
a first transmission line (11) having a first set of electromagnetic modes supporting the propagation of electromagnetic waves (13) at a first phase velocity;
a second transmission line (12) having a second set of electromagnetic modes supporting the propagation of electromagnetic waves (13) at a second phase velocity distinct from the first phase velocity; and
a set of first tunable impedance elements (14) distributed along the first transmission line (11);
a controller (15) configured to control the set of first tunable impedance elements (14) to generate a set of impedance modulations in the first transmission line (11), each impedance modulation of the set producing new tones in the electromagnetic waves (13) propagating in the first transmission line (11);
wherein the controller (15) is configured to individually control each first tunable impedance element (14) to generate the set of impedance modulations with a particular set of associated phases, such that
for a first direction of propagation of the electromagnetic waves (13) in the first transmission line (11), the new tones in the electromagnetic waves (13) in the first transmission line (11) constructively interfere and couple to modes of the second transmission line (12), and
for an opposite second direction of propagation of the electromagnetic waves (13) in the first transmission line (11), the new tones in the electromagnetic waves (13) in the first transmission line (11) destructively interfere and do not couple to the modes of the second transmission line (12).

2. The device (10) according to claim 1, wherein
the set of first tunable impedance elements (14) comprises one of superconducting quantum interference devices configured to be modulated by an external flux, voltage-controlled capacitors configured to be controlled by an external voltage, Josephson junctions, kinetic inductances, a material with second or third order nonlinearity, or any other nonlinear elements configured to be impedance modulated by a pump signal.

3. The device (10) according to one of the claims 1 to 2, wherein
the controller (15) is configured to control the set of first tunable impedance elements (14) to generate the set of impedance modulations at a first frequency and with an associated set of phases, to realize nonreciprocal coupling between electromagnetic waves (13) supported by an electromagnetic mode of the first transmission line (11) and propagating in the first direction of propagation and electromagnetic waves (13) supported by an electromagnetic mode of the second transmission line (12) and propagating in the same first direction of propagation.

4. The device (10) according to one of the claims 1 to 3, wherein
the controller (15) is configured to control the set of first tunable impedance elements (14) to generate the set of impedance modulations at a first frequency with an associated set of phases, to realize nonreciprocal coupling between electromagnetic waves (13) supported by an electromagnetic mode of the first transmission line (11) and propagating in the first direction of propagation and electromagnetic waves (13) supported by an electromagnetic mode of the second transmission line (12) and propagating in the second direction of propagation.

5. The device (10) according to one of the claims 1 to 4, wherein
the controller (15) is configured to control the set of first tunable impedance elements (14) to generate the set of impedance modulations at a plurality of frequencies with associated sets of phases, to realize a set of nonreciprocal couplings between electromagnetic waves (13) supported by electromagnetic modes of one of the two transmission lines (11, 12) and electromagnetic waves (13) supported by electromagnetic modes of the other transmission line (11, 12).

6. The device (10) according to one of the claim 1 to 5, wherein
one modulation frequency and the associated set of phases are configured to realize non-reciprocal coupling and directional exchange of energy between electromagnetic waves (13) supported by an electromagnetic mode of the first transmission line (11) and electromagnetic waves (13) supported by an electromagnetic mode of the second transmission line (12).

7. The device (10) according to one of the claim 1 to 5, wherein
one modulation frequency and the associated set of phases are configured to realize non-reciprocal coupling and directional amplification of an electromagnetic wave (13) propagating in the first transmission line (11) and an electromagnetic wave (13) propagating in the second transmission line (12).

8. The device (10) according to claim 6, wherein
non-reciprocal coupling between electromagnetic waves (13) supported by an electromagnetic mode of one of the two transmission lines (11, 12) designed with lower losses and electromagnetic waves (13) supported by an electromagnetic mode of the other transmission line (11, 12) designed with higher losses is configured to produce nonreciprocal electromagnetic field attenuation.

9. The device (10) according to one of the claims 1 to 8, further comprising
a set of second tunable impedance elements (21) distributed along the second transmission line (12);
wherein the controller (15) is configured to control the set of second tunable impedance elements (21) to generate a second set of impedance modulations in the second transmission line (12), each impedance modulation of the second set producing new tones in the electromagnetic waves (13) propagating in the second transmission line (12);
wherein the controller (15) is configured to individually control each second tunable impedance element (21) to generate the second set of impedance modulations with a particular set of associated phases, such that
for the first direction of propagation of the electromagnetic waves (13) in the second transmission line (12), the new tones in the electromagnetic waves (13) in the second transmission line (12) constructively interfere and couple to modes of the first transmission line (11), and
for the opposite second direction of propagation of the electromagnetic waves (13) in the second transmission line (12), the new tones in the electromagnetic waves (13) in the second transmission line (12) destructively interfere and do not couple to the modes of the first transmission line (11).

10. The device (10) according to one of the claims 1 to 9, wherein
the first transmission line (11) and the second transmission line (12) are configured to have respective electromagnetic modes with dispersion curves that are parallel to each other over a predetermined range of frequencies.

11. The device (10) according to one of the claims 1 to 10, wherein
the electromagnetic waves (13) are radio frequency, RF, waves s or RF noise; or
the electromagnetic waves (13) are optical waves or optical noise and the transmission lines (11, 12) are waveguides.

12. Method (130) of operating a device (10) for non-reciprocal signal transmission, the method (130) comprising
propagating (131) electromagnetic waves (13) supported by a first set of electromagnetic modes of a first transmission line (11) at a first phase velocity in a first direction or in an opposite second direction;
propagating (132) electromagnetic waves (13) supported by a second set of electromagnetic modes of a second transmission line (12) at a second phase velocity in the first direction or in the second direction; and
controlling (133) a set of first tunable impedance elements (14), which are distributed along the first transmission line (11), to generate a set of impedance modulations in the first transmission line (11), each impedance modulation of the set producing new tones in the electromagnetic waves (13) propagating in the first transmission line (11);
wherein each first tunable impedance element (14) is individually controlled to generate the set of impedance modulations with a particular set of associated phases, such that
for a first direction of propagation of the electromagnetic waves (13) in the first transmission line (11), the new tones in the electromagnetic waves (13) in the first transmission line (11) constructively interfere and couple to modes of the second transmission line (12), and
for an opposite second direction of propagation of the electromagnetic waves (13) in the first transmission line (11), the new tones of the electromagnetic waves (13) in the first transmission line (11) destructively interfere and do not couple to the modes of the second transmission line (12).
